# EUROPÄISCHE PATENTSCHRIFT

(11) **EP 3 817 172 B1**
(45) Veröffentlichungstag und Bekanntmachung des Hinweises auf die Patenterteilung: **17.07.2024**
(21) Anmeldenummer: 19206506.8
(22) Anmeldetag: 31.10.2019
(51) Int. Cl.: H02H 3/14, G01R 31/52, H02H 5/10, G01R 19/155, H01R 13/66, H02H 1/00, H02H 11/00

(54) **SCHUTZLEITERÜBERWACHUNGSEINRICHTUNG, STROMVERTEILERVORRICHTUNG UND SCHUTZLEITERÜBERWACHUNGSVERFAHREN**
PROTECTIVE EARTH CONDUCTOR MONITORING DEVICE, POWER DISTRIBUTION DEVICE AND PROTECTIVE EARTH CONDUCTOR MONITORING METHOD
AGENCEMENT DE SURVEILLANCE D'UN CONDUCTEUR DE PROTECTION, DISPOSITIF DE DISTRIBUTION ÉLECTRIQUE ET PROCÉDÉ DE SURVEILLANCE D'UN CONDUCTEUR DE PROTECTION

(43) Veröffentlichungstag der Anmeldung: 05.05.2021
(73) Patentinhaber: Hugo Brennenstuhl GmbH & Co. Kommanditgesellschaft, 72074 Tübingen (DE)
(72) Erfinder: Hoffmann, Axel, 72760 Reutlingen (DE); Böddeker, Jürgen, 72074 Tübingen (DE); Bauer, Wolfram, 72124 Pliezhausen (DE)
(74) Vertreter: Patentanwälte Magenbauer & Kollegen Partnerschaft mbB

(56) Entgegenhaltungen:
- EP-A2- 0 806 825
- DE-A1- 102011 081 950
- DE-A1- 102012 219 542
- DE-B3- 102013 212 739

## Beschreibung

Die Erfindung betrifft eine Schutzleiterüberwachungseinrichtung zur Erkennung einer Schutzleiterstörung einer elektrischen Leitung, wobei die Schutzleiterüberwachungseinrichtung über einen ersten Anschlusspunkt verfügt, der mit einem Schutzleiter der elektrischen Leitung verbindbar ist, eine erste Schaltungsanordnung, die ausgebildet ist, ein elektrisches Messpotential bereitzustellen, das von einem Potential des ersten Anschlusspunkts abhängt, eine zweite Schaltungsanordnung, die ausgebildet ist, ein erstes elektrisches Vergleichspotential bereitzustellen und eine eine Differenzverstärkerschaltung aufweisende Komparatoreinrichtung, die ausgebildet ist, ein Komparatorsignal gemäß einem Vergleich des Messpotentials mit dem ersten Vergleichspotential bereitzustellen.

Eine Schutzleiterüberwachungseinrichtung ist beispielsweise aus der EP 2 945 240 A1 bekannt. Das erste Vergleichspotential wird hier aus einer gleichgerichteten Netzspannung generiert. Ein Messpotential, das innerhalb einer Halbwelle größer ist als das Vergleichspotential, dient als Indikator dafür, dass eine Schutzleiterstörung vorliegt - nämlich dass der Widerstand zur Erdung des Schutzleiters größer ist als er sein sollte.

Die DE 10 2013 212739 B3 betrifft einen Stecker mit zumindest einem Schutzleiterkontakt zum manuellen Stecken in eine Steckdose mit einem korrespondierenden Schutzleitergegenkontakt aufweisend einen Sensor, der derart an dem Stecker angeordnet ist, dass er von einem Benutzer bei einem normalen manuellen Stecken des Steckers in die Steckdose berührt werden muss, wobei der Sensor derart ausgebildet ist und mit dem Schutzleiterkontakt in Wirkverbindung steht, dass bei einer Berührung des Sensors durch den Benutzer und bei einem gleichzeitigen Anliegen einer Spannung an dem Schutzleiterkontakt ein Strom von dem Schutzleiterkontakt über den Sensor durch den Benutzer zur Erde fließt, sowie eine Erkennungseinrichtung zur Erkennung der Spannung an dem Schutzleiterkontakt aufgrund einer Spannungsdifferenz zwischen dem Schutzleiterkontakt und dem Sensor, wobei die Erkennungseinrichtung derart ausgebildet ist, dass sie bei Erkennung einer Spannung an dem Schutzleiterkontakt eine elektrische Verbindung zwischen zumindest zwei im fehlerfreien Betrieb stromführenden Leitern herstellt.

Die DE 10 2012 219542 A1 betrifft eine Schutzleiterüberwachungsvorrichtung.

Die EP 0 806 825 A2 betrifft eine Fehlerstromschutzschalteinrichtung.

Die DE 10 2011 081950 A1 betrifft ein Haushaltsgerät mit einer Schutzvorrichtung.

Eine Aufgabe der Erfindung besteht darin, die Schutzleiterüberwachungseinrichtung der eingangs genannten Art so zu verbessern, dass wenigstens eine andere Schutzleiterstörung erfasst werden kann.

Die Aufgabe wird durch die im Kennzeichen des Anspruchs 1 angegebenen Merkmale gelöst. Erfindungsgemäß verfügt die Schutzleiterüberwachungseinrichtung ferner über eine elektrisch leitende Berührungsfläche zur Berührung durch einen Benutzer, die für den Benutzer zugänglich an der Schutzleiterüberwachungseinrichtung angeordnet ist. Die zweite Schaltungsanordnung ist ausgebildet, das erste Vergleichspotential in Abhängigkeit von einem an der Berührungsfläche anliegenden Potential bereitzustellen.

Auf diese Weise kann eine Schutzleiterstörung erfasst werden, die durch ein auf dem Schutzleiter vorhandenes Fremdpotential verursacht wird. Ist kein Fremdpotential auf dem Schutzleiter, so entspricht das Potential des Schutzleiters in etwa dem lokalen Erdpotential eines Benutzers. Berührt der Benutzer die Berührungsfläche, so stehen das Messpotential und das erste Vergleichspotential in einer bestimmten Beziehung zueinander - beispielsweise ist das Messpotential in diesem Fall größer als das erste Vergleichspotential. Ist nun auf dem Schutzleiter ein Fremdpotential - beispielsweise das Potential eines L-Leiters - vorhanden, so ist die Beziehung zwischen dem Messpotential und dem ersten Vergleichspotential gegenüber dem vorgenannten Fall verändert. Beispielsweise kann bei einem Fremdpotential auf dem Schutzleiter das Messpotential einen Wert annehmen, der kleiner als das erste Vergleichspotential ist. Indem das erste Vergleichspotential in Abhängigkeit von der Berührungsfläche - und damit in Abhängigkeit von dem lokalen Erdpotential des Benutzers gewonnen wird - und der Komparatoreinrichtung zusammen mit dem Messpotential als Vergleichsgröße zugeführt wird, ist es daher möglich, das Vorhandensein eines Fremdpotentials auf dem Schutzleiter als Schutzleiterstörung zu erkennen. Die Stromverteilervorrichtung wird somit verbessert.

Vorteilhafte Weiterbildungen der Stromverteilervorrichtung sind Gegenstand der Unteransprüche.

Die Erfindung betrifft ferner eine Stromverteilervorrichtung zur Bereitstellung einer von der elektrischen Leitung zugeführten Netzspannung an einen oder mehrere Verbraucher, wobei die Stromverteilervorrichtung die Schutzleiterüberwachungseinrichtung umfasst.

Vorzugsweise ist die Berührungsfläche für den Benutzer zugänglich an der Stromverteilervorrichtung angeordnet.

Die Stromverteilervorrichtung dient insbesondere dazu, einem elektrischen Verbraucher Netzspannung zuzuführen und kann zu diesem Zweck mit mindestens einem Phasenleiter, einem Neutralleiter und einem Schutzleiter der elektrischen Leitung, wie z.B. einer Netzleitung eines Verteilers, verbunden werden. Die Stromverteilervorrichtung dient ferner dazu, einen elektrischen Kontakt zwischen einem Schutzleiteranschluss eines elektrischen Verbrauchers und dem Schutzleiter der elektrischen Leitung herzustellen. Die Stromverteilervorrichtung kann ortsfest ausgebildet sein; d.h. die Stromverteilervorrichtung kann ausgebildet sein, im Betrieb z.B. fest mit einer Gebäudeinstallation verbunden zu sein. Beispielsweise kann die Stromverteilervorrichtung als Steckdose bzw. Steckdoseninstallation oder als Vorrichtung in Hutschienenbauweise ausgebildet sein. Alternativ kann die Stromverteilervorrichtung auch ortsveränderlich ausgebildet sein und beispielsweise einen Stecker aufweisen, so dass sie je nach Bedarf an verschiedenen Orten eingesetzt werden kann und mit Anschlüssen verschiedener elektrischer Leitungen lösbar verbunden werden kann. Beispielsweise kann die Stromverteilervorrichtung als Steckdosenleiste, Steckadapter, Leitungsroller, Baustromverteiler, Anschlussleitung oder Verlängerungsleitung ausgebildet sein.

Die Erfindung betrifft ferner ein Schutzleiterüberwachungsverfahren zur Erkennung einer Schutzleiterstörung auf einer mit einem Schutzleiter ausgestatteten elektrischen Leitung. Das Schutzleiterüberwachungsverfahren umfasst die Schritte: Bereitstellen eines Messpotentials, das von einem Potential des Schutzleiters abhängt, Bereitstellen eines ersten elektrischen Vergleichspotentials, das in einem Zustand, in dem ein Benutzer eine elektrisch leitende Berührungsfläche mit seinem Körper berührt, von dem lokalen Erdpotential des Benutzers abhängt, Vergleichen, unter Verwendung einer eine Differenzverstärkerschaltung aufweisenden Komparatoreinrichtung des elektrischen Messpotentials mit dem ersten elektrischen Vergleichspotential und Bereitstellen, gemäß dem Vergleichsergebnis, eines Komparatorsignals zur Erkennung einer Schutzleiterstörung.

Vorzugsweise wird für das erfindungsgemäße Verfahren die hier beschriebene Schutzleiterüberwachungseinrichtung oder Stromverteilervorrichtung eingesetzt.

Exemplarische Details und Ausführungsformen werden nachstehend unter Bezugnahme auf die Zeichnung erläutert. Dabei zeigt
- Figur 1: eine schematische Darstellung einer Stromverteilervorrichtung,
- Figur 2: ein Blockschaltbild einer ersten Schutzleiterüberwachungseinrichtung,
- Figur 3: ein Blockschaltbild einer zweiten Schutzleiterüberwachungseinrichtung,
- Figur 4: ein detailliertes Schaltungsdiagramm einer Schutzleiterüberwachungseinrichtung und
- Figur 5: eine alternative Ausgestaltung einer Schalteinrichtung der Schutzleiterüberwachungseinrichtung.

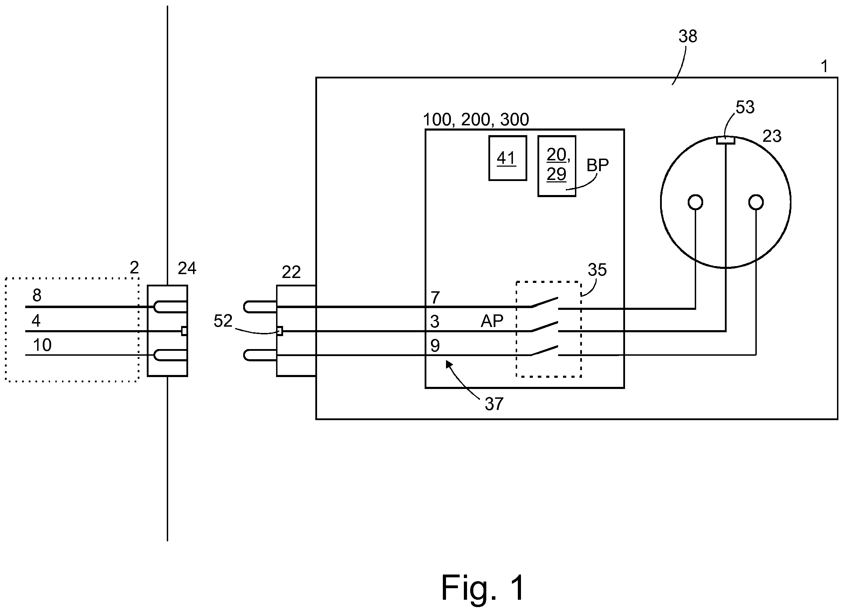

Die Figur 1 zeigt eine Stromverteilervorrichtung 1, die als exemplarischer Anwendungskontext für eine Schutzleiterüberwachungseinrichtung 100, 200 oder 300 dient. Die Schutzleiter-Überwachungseinrichtung 100, 200, 300 kann auch für sich genommen - also ohne die übrigen Komponenten der Stromverteilervorrichtung 1 - bereitgestellt sein.

Die Stromverteilervorrichtung 1 dient dazu, einem in der Figur 1 nicht gezeigten Verbraucher eine Netzspannung bereitzustellen, die von einer elektrischen Leitung 2 zugeführt wird. Die elektrische Leitung 2 wird exemplarisch mittels einer fest installierten Steckdose 24 bereitgestellt.

Die elektrische Leitung 2 ist zweckmäßigerweise eine externe elektrische Leitung 2, insbesondere in Bezug auf die Schutzleiter-Überwachungseinrichtung 100, 200, 300 und/oder die Stromverteilervorrichtung 1. Die elektrische Leitung 2 umfasst einen Schutzleiter 4, einen Phasenleiter 8 und einen Neutralleiter 10.

Rein exemplarisch verfügt die Stromverteilervorrichtung 1 über einen Netzstecker 22, der dazu dient, eine elektrische Verbindung zu der elektrischen Leitung 2 bereitzustellen. Alternativ dazu kann die Stromverteilervorrichtung 1 auch auf andere Art und Weise mit der elektrischen Leitung 2 verbunden werden, beispielsweise über eine feste Verdrahtung.

Ferner verfügt die Stromverteilervorrichtung 1 exemplarisch über eine Steckdose 23, in die ein Verbraucher eingesteckt werden kann.

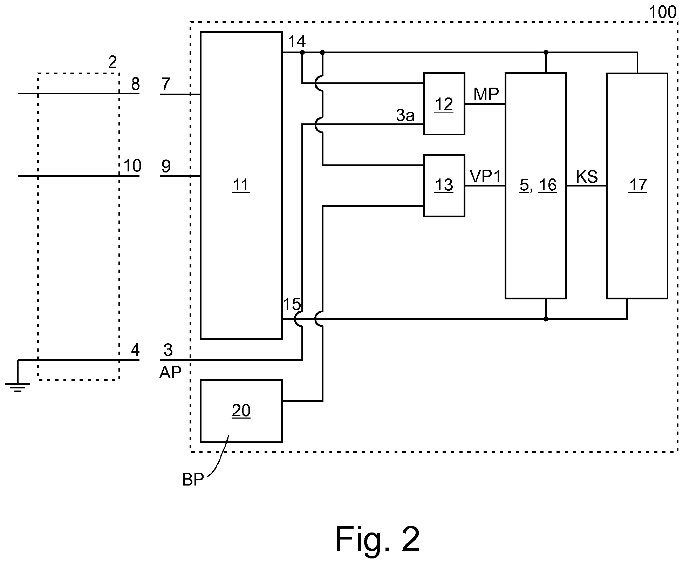

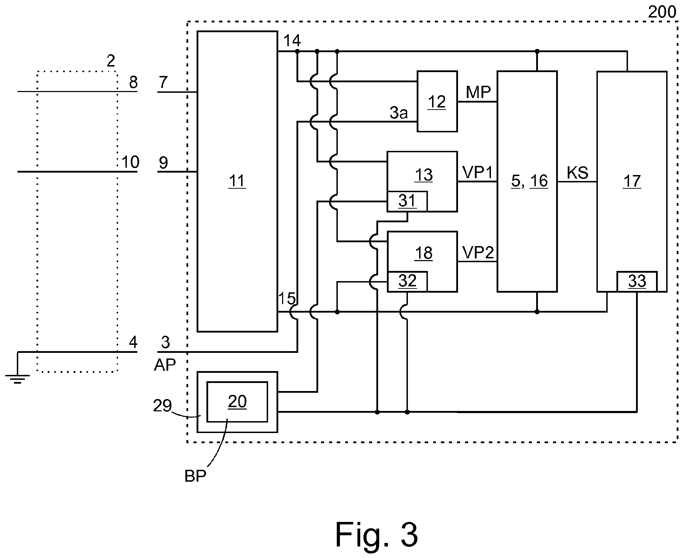

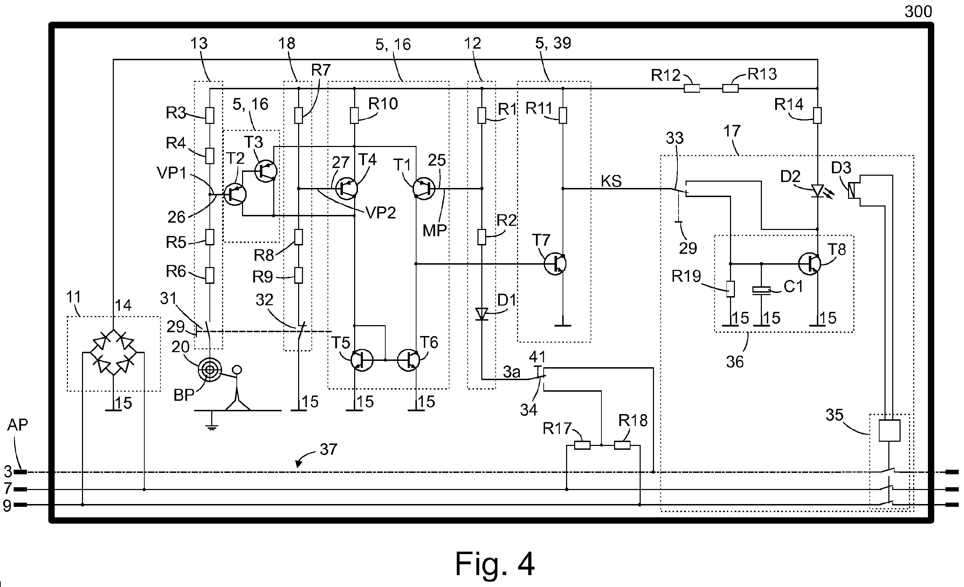

Die Stromverteilervorrichtung 1 verfügt über die Schutzleiterüberwachungseinrichtung 100, 200 oder 300. Blockschaltbilder der Schutzleiterüberwachungseinrichtungen 100 und 200 sind in den Figuren 2 und 3 gezeigt. Exemplarische Schaltungsimplementierungen der Komponenten der Schutzleiterüberwachungseinrichtungen 100 und 200 sind in der Figur 4 anhand der Schutzleiterüberwachungseinrichtung 300 gezeigt. Nachstehende, auf die Schutzleiter-Überwachungseinrichtung 100 oder 200 bezogene Erläuterungen gelten zweckmäßigerweise auch für die Schutzleiterüberwachungseinrichtung 300.

Im Folgenden wird zunächst auf die Schutzleiterüberwachungseinrichtung 100 eingegangen.

Die Schutzleiterüberwachungseinrichtung 100 dient dazu, eine Schutzleiterstörung der elektrischen Leitung 2 zu erkennen. Die Schutzleiterüberwachungseinrichtung 100 verfügt über einen ersten Anschlusspunkt 3, der mit einem Schutzleiter 4 der elektrischen Leitung 2 verbindbar ist. Exemplarisch ist der erste Anschlusspunkt 3 mit einem Schutzleiterkontakt 52 des Netzsteckers 22 elektrisch verbunden und/oder mit einem Schutzleiterkontakt 53 der Steckdose 23 elektrisch verbunden. Die Schutzleiterüberwachungseinrichtung 100 verfügt ferner über eine erste Schaltungsanordnung 12, die ausgebildet ist, ein elektrisches Messpotential MP bereitzustellen. Das elektrische Messpotential MP hängt von einem elektrischen Potential AP des ersten Anschlusspunkts 3 ab.

Die Schutzleiterüberwachungseinrichtung 100 verfügt ferner über eine zweite Schaltungsanordnung 13, die ausgebildet ist, ein erstes elektrisches Vergleichspotenzial VP1 bereitzustellen.

Zudem verfügt die Schutzleiterüberwachungseinrichtung 100 über eine Komparatoreinrichtung 5, die eine Differenzverstärkerschaltung 16 aufweist. Die Komparatoreinrichtung 5 ist ausgebildet, ein Komparatorsignal KS gemäß einem Vergleich des Messpotentials MP mit dem ersten Vergleichspotential VP1 bereitzustellen.

Die Schutzleiterüberwachungseinrichtung 100 verfügt über eine elektrisch leitende Berührungsfläche 20 zur Berührung durch einen Benutzer. Die Berührungsfläche 20 ist für den Benutzer zugänglich an der Schutzleiterüberwachungseinrichtung 100, insbesondere der Stromverteilervorrichtung 1, angeordnet.

Die zweite Schaltungsanordnung 13 ist ausgebildet, das erste Vergleichspotential VP1 in Abhängigkeit von einem an der Berührungsfläche 20 anliegenden elektrischen Potential BP bereitzustellen.

Mit einer derart ausgebildeten Schutzleiterüberwachungseinrichtung 100 wird es möglich, eine Schutzleiterstörung zu erkennen, bei der auf dem Schutzleiter 4 ein Fremdpotential vorhanden ist, da sich das Messpotential MP in diesem Fall relativ zu dem ersten Vergleichspotential VP1 anders verhält, als wenn auf dem Schutzleiter 4 kein Fremdpotential vorhanden ist.

Im Folgenden werden weitere exemplarische Details erläutert.

Die Schutzleiterüberwachungsvorrichtung 100 verfügt über einen zweiten Anschlusspunkt 7, der mit einem Phasenleiter 8 der elektrischen Leitung 2 verbunden werden kann, sowie einen dritten Anschlusspunkt 9, der mit einem Neutralleiter 10 der elektrischen Leitung 2 verbunden werden kann. Im Betrieb ist der ersten Anschlusspunkt 3 mit dem Schutzleiter 4 verbunden, der zweite Anschlusspunkt 7 ist mit dem Phasenleiter 8 verbunden und der dritte Anschlusspunkt 9 ist mit dem Neutralleiter 10 verbunden. Alternativ kann auch der zweite Anschlusspunkt 7 mit dem Neutralleiter 10 verbunden sein und der dritte Anschlusspunkt 9 mit dem Phasenleiter 8.

Insbesondere ist es (ohne Beeinträchtigung der Funktion der Schutzleiterüberwachungsvorrichtung 100 und/oder der Stromverteilervorrichtung 1) möglich, wahlweise den zweiten Anschlusspunkt 7 mit dem Phasenleiter 8 und den dritten Anschlusspunkt 9 mit dem Neutralleiter 10 zu verbinden oder den zweiten Anschlusspunkt 7 mit dem Neutralleiter 10 und den dritten Anschlusspunkt 9 mit dem Phasenleiter 8 zu verbinden.

Die Schutzleiter-Überwachungseinrichtung 100, 200, 300 und/oder die Stromverteilervorrichtung 1 umfasst eine interne elektrische Leitung 37, die zu der Steckdose 23 und/oder einem (nicht gezeigten) Verbraucher führt und mit der elektrisch Leitung 2 elektrisch verbunden werden kann oder elektrisch verbunden ist, exemplarisch über den Netzstecker 22.

Der Netzstecker 22 ist mit dem ersten Anschlusspunkt 3, dem zweiten Anschlusspunkt 7 und dem dritten Anschlusspunkt 9 verbunden. Der Netzstecker 22 oder die Anschlusspunkte 3, 7, 9 sind über die interne elektrische Leitung 37 mit der Steckdose 23 verbindbar oder verbunden. Die interne elektrische Leitung 37 führt exemplarisch über einen Schutzschalter 35, mit dem die interne elektrische Leitung 37 - und damit die Stromversorgung zur Steckdose 23 - unterbrochen werden kann. Die Ansteuerung des Schutzschalters 35 erfolgt zweckmäßigerweise gemäß dem Komparatorsignal KS.

Exemplarisch sind die interne elektrische Leitung 37 und/oder der Schutzschalter 35 Teil der Schutzleiter-Überwachungseinrichtung 100, 200 oder 300. Alternativ dazu können die interne elektrische Leitung 37 und/oder der Schutzschalter 35 zusätzlich zu der Schutzleiter-Überwachungseinrichtung 100, 200, 300 bereitgestellt sein.

Wie in der Figur 1 gezeigt, verfügt die Schutzleiterüberwachungseinrichtung 100 über die elektrisch leitende Berührungsfläche 20. Diese ist exemplarisch außen an der Schutzleiterüberwachungsvorrichtung, insbesondere außen an der Stromverteilervorrichtung 1, angeordnet, so dass sie einem Benutzer zugänglich ist und beispielsweise mit einem Finger des Benutzers berührt werden kann. Exemplarisch verfügt die Stromverteilervorrichtung 1 über ein Gehäuse 38. Außen am Gehäuse 38 ist insbesondere die Berührungsfläche 20 vorgesehen, während sich die anderen Komponenten der Schutzleiterüberwachungseinrichtung 100 zweckmäßigerweise im Gehäuse 38 befinden.

In der Figur 1 ist die Stromverteilervorrichtung 1 als ortsveränderliche Stromverteilervorrichtung dargestellt. Alternativ dazu kann die Stromverteilervorrichtung 1 auch ortsfest ausgebildet sein. Beispielsweise können anstelle der in der Figur 1 gezeigten Steckdose 23 und/oder des Netzsteckers 22 feste Anschlussterminals einer ortsfesten Stromverteilervorrichtung vorgesehen sein. Die nachstehende Beschreibung gilt in Analogie auch auf den Fall, dass die Stromverteilervorrichtung ortsfest ausgebildet ist.

Die Figur 2 zeigt ein Blockschaltbild der Schutzleiterüberwachungseinrichtung 100. Exemplarisch verfügt die Schutzleiterüberwachungseinrichtung 100 ferner über eine Gleichrichteranordnung 11, die ausgebildet ist, eine zwischen dem zweiten Anschlusspunkt 7 und dem dritten Anschlusspunkt 9 anliegende Wechselspannung in eine gleichgerichtete Spannung zu wandeln. Die Gleichrichteranordnung 11 verfügt über zwei Ausgangsanschlusspunkte 14, 15, zwischen denen die Gleichrichteranordnung 11 die gleichgerichtete Spannung bereitstellt.

In der Figur 4 ist eine beispielhafte Schaltungsimplementierung der Gleichrichteranordnung 11 gezeigt, bei der die Gleichrichteranordnung 11 exemplarisch eine Gleichrichterbrücke aufweist. Die Gleichrichterbrücke umfasst exemplarisch vier Dioden. Die Verwendung einer Gleichrichterbrücke ist von Vorteil, da es dabei für die Funktionalität der Schutzleiterüberwachungsvorrichtung keine Rolle spielt, mit welcher Polarität der Phasenleiter 8 und der Neutralleiter 10 an den zweiten und den dritten Anschlusspunkt 7, 9 angeschlossen werden. Insbesondere funktioniert die beschriebene Schutzleiterüberwachungsvorrichtung 100, 200, 300 selbst dann, wenn der Phasenleiter 8 und der Neutralleiter 10 vertauscht werden - also wenn der Phasenleiter 8 an den dritten Anschlusspunkt 9 und der Neutralleiter 10 an den zweiten Anschlusspunkt 7 angeschlossen wird. Dies ist insbesondere von Vorteil bei ortsveränderlichen Stromverteilervorrichtungen 1, da bei diesen in der Regel nicht festgelegt ist, mit welcher Polarität die elektrische Leitung 2 anzuschließen ist.

Die Komparatoreinrichtung 5 wird exemplarisch aus der gleichgerichteten Spannung gespeist. Die gleichgerichtete Spannung kann dabei die Form einer pulsierenden Spannung, insbesondere einer pulsierenden Gleichspannung haben. Eine solche Speisung der Komparatoreinrichtung 5 aus der gleichgerichteten Spannung ist vorteilhaft, da dadurch für die Komparatoreinrichtung 5 keine eigene Spannungsquelle erforderlich ist. Ferner ist so auch kein Glättungskondensator zwischen den Ausgangsanschlüssen 14, 15 der Gleichrichteranordnung 11 erforderlich.

Wie in der Figur 2 gezeigt, ist die erste Schaltungsanordnung 12 exemplarisch zwischen dem ersten Ausgangsanschlusspunkt 14 der Gleichrichteranordnung 11 und dem ersten Anschlusspunkt 3 geschaltet. Zweckmäßigerweise ist die erste Schaltungsanordnung 12 ausgebildet, das Messpotential MP basierend auf einer Spannung bereitzustellen, die zwischen dem ersten Ausgangsanschlusspunkt 14 der Gleichrichteranordnung 11 und dem ersten Anschlusspunkt 3 und/oder einem mit dem ersten Anschlusspunkt 3 elektrisch verbundenen Knoten 3a anliegt. Der Knoten 3a ist insbesondere galvanisch mit dem ersten Anschlusspunkt 3 verbunden, beispielsweise über eine elektrische Leitung.

Gemäß der beschriebenen Ausgestaltung kann das Messpotential MP folglich direkt mit Hilfe eines an dem Ausgangsanschlusspunkt 14 der Gleichrichteranordnung 11 anliegenden elektrischen Potentials generiert werden. Bei dem Ausgangsanschlusspunkt 14 handelt es sich insbesondere um den positiven und/oder oberen Anschluss des Ausgangs der Gleichrichteranordnung 11.

In diesem Zusammenhang sei erwähnt, dass das Messpotential MP zweckmäßigerweise kein festes Potential ist. Insbesondere dann, wenn die Gleichrichteranordnung 11 eine pulsierende Spannung, insbesondere eine pulsierende Gleichspannung, ausgibt und das Messpotential MP auf Basis der pulsierenden Spannung, insbesondere der pulsierenden Gleichspannung, erzeugt wird, kann auch das Messpotential MP als pulsierendes Signal vorliegen.

Vorzugsweise verfügt die erste Schaltungsanordnung 12 über einen ersten Spannungsteiler mit wenigstens zwei Widerständen. Die Figur 4 zeigt eine exemplarische Schaltungsimplementierung der ersten Schaltungsanordnung 12. Hier umfasst die erste Schaltungsanordnung 12 zwei in Reihe zwischen den ersten Ausgangsanschlusspunkt 14 und den Knoten 3a geschaltete Widerstände R1, R2, die zusammen den ersten Spannungsteiler bilden. Zwischen den Widerständen R1, R2 wird das Messpotential MP bereitgestellt.

Wie in der Figur 4 gezeigt, kann die erste Schaltungsanordnung 12 ferner eine Diode D1 umfassen, die in Reihe zu dem ersten Spannungsteiler geschaltet ist. Die Diode D1 ist vorzugsweise vom selben Typ wie die Dioden der Gleichrichteranordnung 11 und soll einen durch die Gleichrichteranordnung 11 verursachten Spannungsabfall nachbilden, um zu verhindern, dass der durch die Gleichrichteranordnung 11 verursachte Spannungsabfall das Vergleichsergebnis der Komparatoreinrichtung 5 beeinflusst.

Wie in der Figur 2 gezeigt, ist die zweite Schaltungsanordnung 13 exemplarisch zwischen den ersten Ausgangsanschlusspunkt 14 und der Berührungsfläche 20 geschaltet. Zweckmäßigerweise ist die zweite Schaltungsanordnung 13 ausgebildet, das erste Vergleichspotential VP1 basierend auf einer Spannung bereitzustellen, die zwischen dem ersten Ausgangsanschlusspunkt 14 und der Berührungsfläche 20 anliegt.

Insbesondere dann, wenn die Gleichrichteranordnung 11 eine pulsierende Spannung, insbesondere eine pulsierende Gleichspannung ausgibt, und das erste Vergleichspotential VP1 auf Basis der pulsierenden Spannung, insbesondere der pulsierenden Gleichspannung, erzeugt wird, kann auch das erste Vergleichspotential VP1 als pulsierendes Signal vorliegen. Vorzugsweise verfügt die zweite Schaltungsanordnung 13 über einen zweiten Spannungsteiler mit wenigstens zwei Widerständen. Die Figur 4 zeigt eine exemplarische Schaltungsimplementierung der zweiten Schaltungsanordnung 13. Hier umfasst die zweite Schaltungsanordnung 13 vier in Reihe zwischen den ersten Ausgangsanschlusspunkt 14 und der Berührungsfläche 20 geschaltete Widerstände R3, R4, R5, R6, die zusammen den zweiten Spannungsteiler bilden. Zwischen den Widerständen R4, R5 wird das erste Vergleichspotential VP1 bereitgestellt.

Die Schutzleiterüberwachungseinrichtung 100 ist grundsätzlich so ausgebildet, dass mithilfe des bereitgestellten Komparatorsignals KS wenigstens zwei verschiedene Zustände - insbesondere ein Normalzustand und ein Fehlerzustand - unterschieden werden können. Der Normalzustand wird hier auch als erster Zustand und der Fehlerzustand als zweiter Zustand bezeichnet. Die Schutzleiterüberwachungseinrichtung 100 ist dementsprechend ausgebildet, das Komparatorsignal KS in Abhängigkeit davon bereitzustellen, ob der erste Zustand oder der zweite Zustand vorliegt; d.h. das Komparatorsignal KS - also der Signalwert und/oder Signalverlauf des Komparatorsignals - ist abhängig davon, welcher Zustand vorliegt.

Der erste Zustand - also der Normalzustand - umfasst insbesondere einen Zustand, bei dem die Berührungsfläche 20 mit dem Körper des Benutzers in elektrisch leitender Verbindung steht und auf dem Schutzleiter 4 kein Fremdpotential vorhanden ist.

Der zweite Zustand - also der Fehlerzustand - umfasst zweckmäßigerweise mehrere Zustände, insbesondere einen Zustand, dass die Berührungsfläche 20 nicht von einem Benutzer berührt wird, einen Zustand, dass die Berührungsfläche 20 mit elektrisch isolierendem Material berührt wird und/oder einen Zustand, dass auf dem Schutzleiter 4 eine Fremdspannung vorhanden ist. Der zweite Zustand ist insbesondere auch dann gegeben, wenn der Benutzer die Berührungsfläche 20 mit einem elektrisch isolierenden Handschuh berührt.

Zweckmäßigerweise sind die Schaltungsanordnungen 12, 13 derart ausgebildet, dass sich in dem ersten Zustand eine erste Beziehung zwischen dem Messpotential MP und dem ersten Vergleichspotential VP1 einstellt - beispielsweise, dass das Vergleichspotential VP1 kleiner ist als das Messpotential MP - und dass sich in dem zweiten Zustand eine zweite Beziehung zwischen dem Messpotential MP und dem ersten Vergleichspotential VP1 einstellt - beispielsweise, dass das Vergleichspotential VP1 größer ist als das Messpotential MP.

Zweckmäßigerweise sind die Schaltungsanordnungen 12, 13 derart ausgebildet, dass in dem Fall, in dem an der Berührungsfläche 20 und dem ersten Anschlusspunkt 3 in etwa dasselbe Potential anliegt, das Vergleichspotential VP1 kleiner ist als das Messpotential MP. Sofern die Schaltungsanordnungen 12, 13 Spannungsteiler umfassen, kann dies beispielsweise dadurch erzielt werden, dass der zweite Spannungsteiler (der zweiten Schaltungsanordnung 13) ein kleineres Teilerverhältnis als der erste Spannungsteiler (der ersten Schaltungsanordnung 12) aufweist.

Ferner sind die Schaltungsanordnungen 12, 13 zweckmäßigerweise derart ausgebildet, dass dann, wenn die Berührungsfläche 20 mit einem isolierenden Gegenstand - z.B. hochohmig - oder nicht berührt wird und/oder wenn ein Fremdpotential, insbesondere ein von einem Phasenleiter stammendes Fremdpotential, auf dem Schutzleiter 4 bzw. dem ersten Anschlusspunkt 3 vorhanden ist, das Vergleichspotential VP1 größer ist als das Messpotential MP.

Die Komparatoreinrichtung 5 ist zwischen die beiden Ausgangsanschlusspunkte 14, 15 der Gleichrichteranordnung 11 geschaltet und wird zweckmäßigerweise von einer pulsierenden gleichgerichteten Spannung, insbesondere einer pulsierenden Gleichspannung, versorgt. Die Komparatoreinrichtung 5 verfügt, wie vorstehend bereits erwähnt, über eine Differenzverstärkerschaltung 16. Der Vergleich zwischen dem Messpotential MP und dem ersten Vergleichspotential VP1 findet mittels der Differenzverstärkerschaltung 16 statt. Die Komparatoreinrichtung 5 verfügt über einen ersten Eingang 25, an dem das Messpotential MP anliegt, und einen zweiten Eingang 26, an dem das erste Vergleichspotential VP1 anliegt.

Die Differenzverstärkerschaltung 16 kann einen Differenzverstärker mit bekannter Topologie aufweisen. Beispielsweise kann die Differenzverstärkerschaltung 16 einen Differenzverstärker mit zwei gleichartigen Transistoren als Eingänge, einem Emitterwiderstand, einem Stromspiegel und/oder Lastwiderständen aufweisen. Die Figur 4 zeigt eine exemplarische Ausgestaltung einer Differenzverstärkerschaltung 16. Hier verfügt der Differenzverstärker über einen Transistor T1, der den ersten Eingang 25 bereitstellt, und einen Transistor T2, der den zweiten Eingang 26 bereitstellt. Ferner verfügt der Differenzverstärker über einen Emitterwiderstand R10 sowie zwei Transistoren T5, T6, die zusammen einen Stromspiegel bilden.

Gemäß einer (in den Figuren nicht gezeigten) alternativen Ausgestaltung umfasst der Differenzverstärker anstelle des Stromspiegels - also anstelle der beiden Transistoren T5, T6 - zwei Lastwiderstände.

Der Differenzverstärker ist zwischen die beiden Ausgangsanschlusspunkte 14, 15 der Gleichrichteranordnung 11 geschaltet. Rein exemplarisch verfügt der Differenzverstärker ferner über einen Transistor T3, der zusammen mit dem Transistor T2 eine Darlington-Schaltung bildet.

Vorzugsweise sind die Transistoren des Differenzverstärkers Bipolartransistoren. Insbesondere sind die Transistoren des Differenzverstärkers als Hochvolttransistoren ausgebildet. Die Transistoren T1, T2, T3 sind vorzugsweise als PNP-Transistoren ausgebildet und die Transistoren T5, T6 als NPN-Transistoren.

Gemäß einer (in den Figuren nicht gezeigten) alternativen Ausgestaltung ist die Differenzverstärkerschaltung gespiegelt zu der gezeigten Differenzverstärkerschaltung 16 ausgeführt. Insbesondere sind anstelle der PNP-Transistoren (beispielsweise der Transistoren T1, T2, T3) NPN-Transistoren vorhanden und anstelle der NPN Transistoren (beispielsweise der Transistoren T5, T6) PNP-Transistoren vorhanden.

Gemäß einer weiteren (in den Figuren nicht gezeigten) alternativen Ausgestaltung sind die Transistoren des Differenzverstärkers Feldeffekt-Transistoren, insbesondere Metall-Oxid-Halbleiter-Feldeffekttransistoren.

Durch die Verwendung einer Differenzverstärkerschaltung wird die Erkennung der Schutzleiterstörung über einen differentiellen Vergleich zweier Potentiale und/oder Eingangsspannungen erzielt. Der differentielle Vergleich hat den Vorteil, dass Störgrößen, wie z.B. Temperatur- oder Prozessschwankungen, unterdrückt werden können.

Vorzugsweise verfügt die Komparatoreinrichtung 5 über eine Inverterstufe zur Invertierung des Komparatorsignals KS. Exemplarisch verfügt die Komparatoreinrichtung 5 über eine Emitterschaltung 39, die vorzugsweise von der gleichgerichteten Spannung der Gleichrichteranordnung 11 versorgt wird und deren Eingang mit dem (in Hinblick auf den ersten Eingang 25) invertierenden Ausgang des Differenzverstärkers verbunden ist. Am Ausgang der Emitterschaltung 39 wird das Komparatorsignal KS bereitgestellt. In der Figur 4 ist eine exemplarische Schaltungsimplementierung der Emitterschaltung 39 gezeigt, bei der ein Widerstand R11 und ein exemplarisch als NPN-Transistor ausgebildeter Transistor T7 in Reihe zwischen die Ausgangsanschlusspunkte 14, 15 der Gleichrichteranordnung 11 geschaltet sind. Die Emitterschaltung 39 stellt insbesondere die vorgenannte Inverterstufe zur Invertierung des Komparatorsignals KS dar. Anstelle der Emitterschaltung kann auch eine andere Inverterstufe vorhanden sein. Ferner kann die Inverterstufe, insbesondere die Emitterschaltung 39, auch weggelassen werden. In diesem Fall kann das Komparatorsignal KS beispielsweise an einem Ausgang der Differenzverstärkerschaltung 16 bereitgestellt werden. Ferner kann das Komparatorsignal KS einem Microcontroller zugeführt werden, der zweckmäßigerweise die Funktion der Schalteinrichtung 17 ganz oder teilweise erfüllt und insbesondere eine Ansteuerung des Schutzschalters 35 gemäß dem Komparatorsignal KS bewirkt. Beispielsweise kann das Speicherglied 36 durch den Microcontroller realisiert sein.

Die Schutzleiterüberwachungseinrichtung 100, insbesondere die Stromverteilervorrichtung 1, umfasst exemplarisch den Schutzschalter 35 zur Unterbrechung der mit dem ersten Anschlusspunkt 3, zweiten Anschlusspunkt 7 und dritten Anschlusspunkt 9 verbundenen internen elektrischen Leitung 37. Zweckmäßigerweise ist die Stromverteilervorrichtung 1 ausgebildet, in Ansprechen auf das Komparatorsignal KS die interne elektrische Leitung 37 mit Hilfe des Schutzschalters 35 zu unterbrechen. Vorzugsweise ist die Stromverteilervorrichtung 1 ausgebildet, die interne elektrische Leitung 37 in Ansprechen auf den ersten Komparatorsignal-Zustand nicht zu unterbrechen und die interne elektrische Leitung 37 in Ansprechen auf den zweiten Komparatorsignal-Zustand zu unterbrechen.

Zweckmäßigerweise ist der Schutzschalter 35 ausgebildet, (im nachstehend erläuterten ersten Prüfmodus und/oder im nachstehend erläuterten zweiten Prüfmodus) einen Unterbrechungs-Zustand, in dem der Schutzschalter 35 die interne elektrische Leitung 37 unterbricht, beizubehalten, insbesondere zu speichern, zweckmäßigerweise wenigstens solange, bis die Betätigungseinrichtung 29 (erneut) betätigt wird. Die Ansteuerung des Schutzschalters 35 kann zweckmäßigerweise auch durch einen Microcontroller realisiert sein.

Die Ansteuerung des Schutzschalters 35 erfolgt exemplarisch über eine Schalteinrichtung 17. Der Schutzschalter 35 kann dabei einen Teil der Schalteinrichtung 17, insbesondere der Schutzleiterüberwachungseinrichtung, bilden, oder zusätzlich zu der Schutzleiterüberwachungseinrichtung bereitgestellt werden.

In der Figur 4 ist eine exemplarische Schaltungsimplementierung der Schalteinrichtung 17 gezeigt. Die Schalteinrichtung 17 verfügt hier über einen Optokoppler, der von der Leuchtdiode D2 und der Photodiode D3 gebildet wird. Die Leuchtdiode D2 ist exemplarisch zwischen den ersten Ausgangsanschlusspunkt 14 und das Komparatorsignal KS bzw. den Ausgang der Komparatoranordnung 5 geschaltet. Der Optokoppler ist ausgebildet, den Schutzschalter 35 anzusteuern, um zu bewirken, dass die interne elektrische Leitung 37 wahlweise unterbrochen oder nicht unterbrochen wird.

Exemplarisch wird die interne elektrische Leitung 37 in Ansprechen darauf unterbrochen, dass das Messpotential MP kleiner als das erste Vergleichspotential VP1 ist. In diesem Fall nimmt das Komparatorsignal KS einen niedrigen Pegel, insbesondere einen L-Pegel, an, so dass ein Strom durch die Leuchtdiode D2 fließt und die Photodiode D3 angeregt wird und ein Signal bereitstellt, das wiederum bewirkt, dass der Schutzschalter 35 die interne elektrische Leitung 37 unterbricht.

Es sei angemerkt, dass die Kopplung zwischen dem Schutzschalter 35 und dem Komparatorsignal KS alternativ auch ohne Optokoppler ausgeführt sein kann.

Vorzugsweise verfügt die Schutzleiterüberwachungseinrichtung 100, insbesondere die Stromverteilervorrichtung 1, über eine Betätigungseinrichtung 29, insbesondere eine Taste und/oder einen Schalter, an der die Berührungsfläche 20 angeordnet ist.

Die Schutzleiterüberwachungseinrichtung 100, insbesondere die Stromverteilervorrichtung 1, ist insbesondere derart ausgebildet, dass die Betätigungseinrichtung 29 zwingend betätigt werden muss, damit mit der Schutzleiterüberwachungseinrichtung 100, insbesondere der Stromverteilervorrichtung 1, eine Netzspannung bereitgestellt werden kann. Beispielsweise kann die Schutzleiterüberwachungseinrichtung 100, insbesondere die Stromverteilervorrichtung 1, ausgebildet sein, die interne elektrische Leitung 37 zu unterbrechen, bis die Betätigungseinrichtung 29 wenigstens einmal betätigt wurde. Dadurch, dass die Betätigungseinrichtung 29 zur Inbetriebnahme der Schutzleiterüberwachungseinrichtung 100, insbesondere der Stromverteilervorrichtung 1, betätigt werden muss und dass die Berührungsfläche 20 auf der Betätigungseinrichtung 29 angeordnet ist, kann sichergestellt werden, dass der Benutzer die Berührungsfläche 20 bei der Inbetriebnahme wenigstens einmal berühren muss, so dass das erste Vergleichspotential VP1 erzeugt werden kann und eine Prüfung dahingehend stattfinden kann, ob der Fehlerzustand gegeben ist, also ob beispielsweise auf dem Schutzleiter 4 ein Fremdpotential vorhanden ist.

Die Figur 3 zeigt ein Blockschaltbild der Schutzleiterüberwachungseinrichtung 200. Die Schutzleiterüberwachungseinrichtung 200 stellt eine Weiterbildung der vorstehend diskutierten Schutzleiterüberwachungseinrichtung 100 dar. Die die Schutzleiterüberwachungseinrichtung 100 betreffenden Ausführungen gelten auch für die Schutzleiterüberwachungseinrichtung 200.

Die Schutzleiterüberwachungseinrichtung 200 verfügt zusätzlich über eine dritte Schaltungsanordnung 18, die ausgebildet ist, ein zweites elektrisches Vergleichspotential VP2 bereitzustellen. Zweckmäßigerweise ist die Komparatoreinrichtung 5 ausgebildet, das Komparatorsignal KS basierend auf einem Vergleich des elektrischen Messpotentials MP mit dem zweiten elektrischen Vergleichspotential VP2 bereitzustellen.

Wie in der Figur 3 gezeigt, ist die dritte Schaltungsanordnung 18 exemplarisch zwischen dem ersten Ausgangsanschlusspunkt 14 und dem zweiten Ausgangsanschlusspunkt 15 der Gleichrichteranordnung 11 geschaltet. Zweckmäßigerweise ist die dritte Schaltungsanordnung 18 ausgebildet, das zweite Vergleichspotential VP2 basierend auf einer Spannung bereitzustellen, die zwischen dem ersten Ausgangsanschlusspunkt 14 und dem zweiten Ausgangsanschlusspunkt 15 anliegt.

In diesem Zusammenhang sei erwähnt, dass das zweite Vergleichspotential VP2 zweckmäßigerweise kein festes Potential ist. Insbesondere dann, wenn die Gleichrichteranordnung 11 eine pulsierende Spannung, insbesondere eine pulsierende Gleichspannung, ausgibt und das zweite Vergleichspotential VP2 auf Basis der pulsierenden Spannung, insbesondere der pulsierenden Gleichspannung, erzeugt wird, kann auch das zweite Vergleichspotential VP2 als pulsierendes Signal vorliegen.

Vorzugsweise verfügt die dritte Schaltungsanordnung 18 über einen dritten Spannungsteiler mit wenigstens zwei Widerständen. Die Figur 4 zeigt eine exemplarische Schaltungsimplementierung der dritten Schaltungsanordnung 18. Hier umfasst die dritte Schaltungsanordnung 18 drei in Reihe zwischen den ersten Ausgangsanschlusspunkt 14 und den zweiten Ausgangsanschluss 15 geschaltete Widerstände R7, R8, R9, die zusammen den dritten Spannungsteiler bilden. Zwischen den Widerständen R7, R8 wird das zweite Vergleichspotential VP2 bereitgestellt.

Der Vergleich des Messpotentials MP mit dem zweiten Vergleichspotential VP2 dient insbesondere dazu, herauszufinden, ob der Schutzleiter 4 eine Schutzleiterstörung wie beispielsweise eine Unterbrechung aufweist. Im Falle einer Unterbrechung des Schutzleiters 4 ist (in einem Zustand, in dem der Schutzleiter 4 mit dem ersten Anschlusspunkt 3 verbunden ist) das Messpotential MP größer als wenn der Schutzleiter 4 keine Unterbrechung aufweist.

Zweckmäßigerweise ist die Schutzleiterüberwachungseinrichtung 200 ausgebildet, das Komparatorsignal in Abhängigkeit davon bereitzustellen, ob der Schutzleiter 4 unterbrochen ist oder nicht, in einem Zustand, in dem der Schutzleiter 4 mit dem ersten Anschlusspunkt 3 verbunden ist. Die erste Schaltungsanordnung 12 und die dritte Schaltungsanordnung 18 sind zweckmäßigerweise derart ausgestaltet, dass das Messpotential MP dann, wenn der Schutzleiter 4 unterbrochen ist, größer als das zweite Vergleichspotential VP2 ist, und dann, wenn der Schutzleiter 4 nicht unterbrochen ist, kleiner ist als das zweite Vergleichspotential VP2.

Das Messpotential bildet dabei insbesondere den elektrischen Widerstand von dem ersten Anschlusspunkt 3 zu der Erdung des Schutzleiters 4 ab. Das heißt, das Messpotential verhält sich in Entsprechung zu dem Widerstand. Überschreitet das Messpotential MP das zweite elektrische Vergleichspotential VP2, so deutet dies darauf hin, dass der Widerstand auf dem Schutzleiter 4 größer ist als er sein sollte, und dass somit eine Schutzleiterstörung vorliegen kann.

Wie vorstehend bereits erläutert, sind die Schaltungsanordnungen 12 und 18 in der Figur 4 exemplarisch als Spannungsteiler ausgebildet. Vorzugsweise sind die Widerstände der Spannungsteiler so gewählt, dass ein Schwellenwert definiert wird, der zweckmäßigerweise dem maximal zulässigen Widerstand auf dem Schutzleiter 4 entspricht. Beispielsweise entspricht der Schwellenwert einem niederohmigen Widerstand (beispielsweise 1 kOhm) auf dem Schutzleiter 4.

Zweckmäßigerweise verfügt die Schutzleiterüberwachungseinrichtung 200 über ein insbesondere als Tiefpassglied ausgebildetes Speicherglied, das insbesondere dann, wenn das Messpotential MP mit dem zweiten Vergleichspotential VP2 verglichen wird, mit dem Ausgang der Komparatoreinrichtung 5 verbunden ist und das Komparatorsignal KS empfängt. Die Ansteuerung des Schutzschalters 35 erfolgt dann zweckmäßigerweise gemäß dem tiefpassgefilterten Komparatorsignal KS.

In der Figur 4 ist eine exemplarische Schaltungsimplementierung eines Speicherglieds 36 gezeigt. Exemplarisch umfasst das Speicherglied 36 einen Transistor T8, einen Widerstand R19 und einen Kondensator C1. Der Transistor T8 ist vorzugsweise als NPN-Transistor ausgebildet. Das Speicherglied 36, insbesondere der Kondensator C1, wird gemäß dem Komparatorsignal KS aufgeladen oder entladen. Gemäß dem Ladezustand des Speicherglieds 36 wird der Transistor T8 geschaltet. Ab einem gewissen Ladezustand des Speicherglieds 36 wird der Transistor T8 leitend und es erfolgt eine Ansteuerung des Schutzschalters 35, so dass die interne elektrische Leitung 37 unterbrochen wird. Exemplarisch fließt bei leitendem Transistor T8 ein Strom durch die Leuchtdiode D2, so dass die Photodiode D3 ein Signal bereitstellt, das die Ansteuerung des Schutzschalters 35 bewirkt.

Eine Tiefpassfilterung des Komparatorsignals KS ist insbesondere dann von Vorteil, wenn das Messpotential MP und das zweite Vergleichspotential VP2 von einer pulsierenden Spannung, insbesondere von einer pulsierenden Gleichspannung, abgeleitet werden, da in diesem Fall das Komparatorsignal aufgrund des transienten Verhaltens der Schaltung auch dann zeitweise kippen kann, wenn keine Schutzleiterstörung vorliegt. Durch die Verwendung des Speicherglieds 36 wird verhindert, dass dieses zeitweise Kippen zu einer Ansteuerung des Schutzschalters 35 führt.

Zweckmäßigerweise ist die Schutzleiterüberwachungsvorrichtung 200 ausgebildet, wahlweise einen ersten Prüfmodus oder einen zweiten Prüfmodus einzunehmen. In dem ersten Prüfmodus kann dabei ein Vergleich zwischen dem Messpotential MP und dem ersten Vergleichspotential VP1 erfolgen und in dem zweiten Prüfmodus ein Vergleich zwischen dem Messpotential MP und dem zweiten Vergleichspotential VP2. Dementsprechend ist die Komparatoreinrichtung 5 insbesondere ausgebildet, in dem ersten Prüfmodus das Komparatorsignal KS basierend auf dem Vergleich zwischen dem Messpotential MP und dem ersten Vergleichspotential VP1 bereitzustellen, und ausgebildet, in dem zweiten Prüfmodus das Komparatorsignal KS basierend auf dem Vergleich zwischen dem Messpotential MP und dem zweiten Vergleichspotential VP2 bereitzustellen.

Zweckmäßigerweise ist die Komparatoreinrichtung 5 ausgebildet, im ersten Prüfmodus kein Vergleich mit dem zweiten Vergleichspotential VP2 und im zweiten Prüfmodus kein Vergleich mit dem ersten Vergleichspotential VP1 durchzuführen.

Vorzugsweise findet in beiden Prüfmodi der jeweils durchgeführte Vergleich mit derselben Schaltung - insbesondere der Differenzverstärkerschaltung 16 - statt. So ist die Differenzverstärkerschaltung 16 zweckmäßigerweise ausgebildet, in dem ersten Prüfmodus das Messpotential MP mit dem ersten Vergleichspotential VP1 zu vergleichen, und ausgebildet, in dem zweiten Prüfmodus das Messpotential MP mit dem zweiten Vergleichspotential VP2 zu vergleichen.

Für die Umschaltung zwischen den beiden Prüfmodi ist zweckmäßigerweise eine Betätigungseinrichtung vorgesehen, beispielsweise die vorstehend bereits diskutierte Betätigungseinrichtung 29. Exemplarisch ist an der Betätigungseinrichtung die Berührungsfläche 20 angeordnet. Die Betätigungseinrichtung 29 dient also zweckmäßigerweise dazu, zwischen den beiden Prüfmodi umzuschalten. Beispielsweise wird durch Betätigen, insbesondere Drücken, der Betätigungseinrichtung 29 in den ersten Prüfmodus umgeschaltet und durch Nicht-Betätigen der Betätigungseinrichtung 29 wird in den zweiten Prüfmodus umgeschaltet.

Um die beiden Vergleiche vornehmen zu können, verfügt die Differenzverstärkerschaltung 16 insbesondere über drei Eingänge 25, 26, 27. Wie exemplarisch in der Figur 4 gezeigt, ist der dritte Eingang 27 parallel zum zweiten Eingang 26 geschaltet. In der gezeigten exemplarischen Schaltungsimplementierung ist der zweite Eingang 26 ein Differenzverstärkereingang und wird durch eine Darlington-Schaltung gebildet, die die beiden Transistoren T2 und T3 umfasst. Alternativ kann der zweite Eingang 26 beispielsweise auch nur einen Transistor umfassen. Der dritte Eingang 27 wird nun bereitgestellt, in dem parallel zu dem zweiten Eingang 26 - hier parallel zu der Darlington-Schaltung aus den Transistoren T2 und T3 - ein Transistor T4 geschaltet ist.

Zweckmäßigerweise ist die erste Schaltungsanordnung 12 ausgebildet, im ersten und zweiten Prüfmodus das Messpotential MP an dem ersten Eingang 25 bereitzustellen, die zweite Schaltungsanordnung 13 ist ausgebildet, im ersten Prüfmodus das erste Vergleichspotential VP1 an dem zweiten Eingang 26 bereitzustellen, und die dritte Schaltungsanordnung 18 ist ausgebildet, im zweiten Prüfmodus das zweite Vergleichspotential VP2 an dem dritten Eingang 27 bereitzustellen.

Die Schutzleiterüberwachungsvorrichtung 200 ist dabei insbesondere ausgebildet, in dem ersten Prüfmodus zu verhindern, dass der Differenzverstärkerschaltung 16 das zweite Vergleichspotential VP2 bereitgestellt wird, und in dem zweiten Prüfmodus zu verhindern, dass der Differenzverstärkerschaltung 16 das erste Vergleichspotential VP1 bereitgestellt wird.

Zu diesem Zweck können beispielsweise die in den Figuren 3 und 4 gezeigten Schalter 31, 32 vorgesehen sein. Der erste Schalter 31 dient exemplarisch dazu, die elektrische Verbindung zwischen dem zweiten Eingang 26, exemplarisch dem Widerstand R6, und der Berührungsfläche 20 im ersten Prüfmodus herzustellen und im zweiten Prüfmodus zu unterbrechen. Der zweite Schalter 32 dient exemplarisch dazu, die elektrische Verbindung zwischen dem dritten Eingang 27, exemplarisch dem Widerstand R9, und dem zweiten Ausgangsanschlusspunkte 15 im zweiten Prüfmodus herzustellen und im ersten Prüfmodus zu unterbrechen.

Die Schalter 31, 32 können, wie in den Figuren 3 und 4 gezeigt, Teil der Schaltungsanordnungen 13, 18 bilden und insbesondere in Reihe zu den dort jeweils vorgesehenen Widerständen geschaltet sein.

Zweckmäßigerweise können beide Schalter 31, 32 über die Betätigungseinrichtung 29 betätigt werden. Zweckmäßigerweise lässt sich die Betätigungseinrichtung 29 in zwei verschiedene Stellungen versetzen und in jeder der Stellungen ist einer der Schalter 31, 32 geöffnet und der andere geschlossen.

Vorzugsweise ist die Stromverteilervorrichtung 1 ferner ausgebildet, gemäß dem aktuellen Prüfmodus anzupassen, wie die Unterbrechung der internen elektrischen Leitung 37, insbesondere die Ansteuerung des Schutzschalters 35, von dem Komparatorsignal KS abhängt.

Insbesondere ist die Stromverteilervorrichtung 1 ausgebildet, im ersten Prüfmodus die interne elektrische Leitung 37 in Ansprechen auf einen ersten Komparatorsignal-Zustand des Komparatorsignals KS nicht zu unterbrechen und in Ansprechen auf einen vom ersten Komparatorsignal-Zustand verschiedenen zweiten Komparatorsignal-Zustand des Komparatorsignals zu unterbrechen. Ferner ist die Stromverteilervorrichtung 1 ausgebildet, im zweiten Prüfmodus die interne elektrische Leitung 37 in Ansprechen auf den zweiten Komparatorsignal-Zustand nicht zu unterbrechen und in Ansprechen auf den ersten Komparatorsignal-Zustand zu unterbrechen. Mit einem Komparatorsignal-Zustand ist insbesondere ein Signalwert oder ein Signalverlauf des Komparatorsignals KS gemeint. Beispielsweise sind mit den beiden Komparatorsignal-Zuständen ein L-Pegel (also ein Low-Pegel) und ein H-Pegel (also ein High-Pegel) des Komparatorsignals KS gemeint.

Exemplarisch hat das Komparatorsignal KS im ersten Komparatorsignal-Zustand einen H-Pegel und im zweiten Komparatorsignal-Zustand einen L-Pegel.

Zweckmäßigerweise ist die Stromverteilervorrichtung 1 ausgebildet, im ersten Prüfmodus die interne elektrische Leitung 37 in Ansprechen auf einen Komparatorsignal mit einem L-Pegel, insbesondere einem niedrigen Pegel, zu unterbrechen und in Ansprechen auf ein Komparatorsignal mit einem H-Pegel, insbesondere einem hohen Pegel nicht zu unterbrechen. Bei diesem Beispiel ist die Stromverteilervorrichtung 1 vorzugsweise ferner ausgebildet, im zweiten Prüfmodus die interne elektrische Leitung 37 in Ansprechen auf ein Komparatorsignal KS mit einem H-Pegel, insbesondere einem hohen Pegel, zu unterbrechen und in Ansprechen auf ein Komparatorsignal mit einem L-Pegel, insbesondere einem niedrigen Pegel nicht zu unterbrechen.

Im ersten Prüfmodus liegt vorzugsweise bei dem ersten Komparatorsignal-Zustand der Normalzustand vor und bei dem zweiten Komparatorsignal-Zustand der Fehlerzustand. Im zweiten Prüfmodus liegt vorzugsweise bei dem zweiten Komparatorsignal-Zustand der Normalzustand vor und bei dem ersten Komparatorsignal-Zustand der Fehlerzustand.

Exemplarisch verfügt die Schalteinrichtung 17 über einen dritten Schalter 33, über den die Abhängigkeit zwischen dem Komparatorsignal KS und der Ansteuerung des Schutzschalters 35 eingestellt werden kann. In einer ersten Schaltstellung, die zweckmäßigerweise im ersten Prüfmodus eingenommen wird, verbindet der Schalter 33 den Ausgang der Komparatoreinrichtung 5 - insbesondere das Komparatorsignal KS - mit der Diode D2, so dass bei einem Komparatorsignal KS mit niedrigem Pegel (also L-Pegel) ein Strom durch die Diode D2 fließt. In einer zweiten Schaltstellung, die zweckmäßigerweise im zweiten Prüfmodus eingenommen wird, verbindet der Schalter 33 den Ausgang der Komparatoreinrichtung 5 - insbesondere das Komparatorsignal KS - mit dem Speicherglied 36, so dass bei einem Komparatorsignal KS mit hohem Pegel (also H-Pegel) ein Strom durch die Diode D2 fließt.

Zweckmäßigerweise wird der dritte Schalter 33 über die Betätigungseinrichtung 29 betätigt.

In dem Beispiel der Figur 4 umfasst die Schutzleiterüberwachungseinrichtung 300 ferner die der Strombegrenzung dienenden Widerstände R12, R13, R14. Es sei in diesem Zusammenhang angemerkt, dass diese Widerstände optionale Merkmale darstellen, die zur Lösung der Aufgabe nicht zwingend erforderlich sind.

Die in der Figur 4 gezeigten Widerstände R1 bis R19 und der Kondensator C1 können beispielsweise mit den folgenden exemplarischen Werte implementiert werden: R1 = 56 kQ, R2 = 56 kQ, R3 = 60 MS2, R4 = 60 MS2, R5 = 1 MS2, R6 = 1 MS2, R7 = 56 kQ, R8 = 56 kQ, R9 = 1 kQ, R10 = 120 kQ, R11 = 470 kQ, R12 = 10 kQ, R13 = 8,2 kQ, R14 = 56 kQ, R15 = 220 kQ, R16 = 680 Q, R17 = 470 kQ, R18 = 470 kQ, R19 = 470 kQ, C1 = 22 uF.

Wie vorstehend bereits erwähnt, ist das Teilerverhältnis des zweiten Spannungsteilers (der zweiten Schaltungsanordnung 13) vorzugsweise kleiner als das des ersten Spannungsteilers (der ersten Schaltungsanordnung 12). Ferner ist das Teilerverhältnis des dritten Spannungsteilers (der dritten Schaltungsanordnung 18) vorzugsweise größer als das des ersten Spannungsteilers (der ersten Schaltungsanordnung 12).

Zweckmäßigerweise ist das Teilerverhältnis des zweiten Spannungsteilers ein Bruchteil des Teilerverhältnisses des ersten Spannungsteilers, beispielsweise 1/61. Zweckmäßigerweise ist das Teilerverhältnis des dritten Spannungsteilers wenigstens 0,5 % - 0,8 % größer als das des ersten Spannungsteilers. Exemplarisch beträgt das erste Teilerverhältnis 0,500, das zweite Teilerverhältnis 0,0164 und das dritte Teilerverhältnis 0,504.

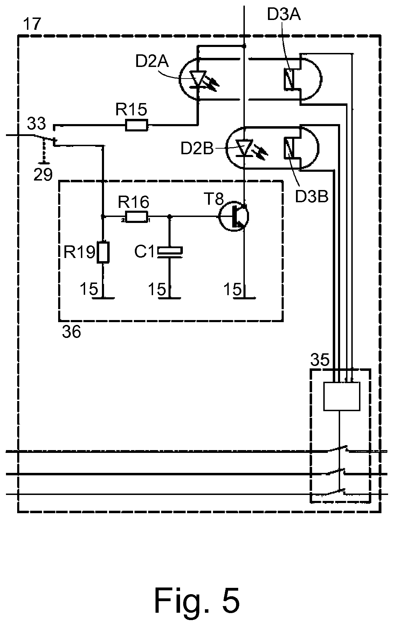

Die Figur 5 zeigt eine weitere exemplarische Schaltungsimplementierung der Schalteinrichtung 17. Die Schalteinrichtung 17 verfügt hier über zwei Optokoppler: einen ersten Optokoppler, der von einer ersten Leuchtdiode D2A und einer ersten Photodiode D3A gebildet wird und einen zweiten Optokoppler, der von einer zweiten Leuchtdiode D2A und einer zweiten Photodiode D3B gebildet wird. Die erste Leuchtdiode D2A ist im ersten Prüfmodus mit dem Ausgang der Komparatoreinrichtung 5 verbunden und im zweiten Prüfmodus nicht. Im ersten Prüfmodus leuchtet die erste Leuchtdiode D2A abhängig davon, welcher Komparatorsignal-Zustand vorliegt. Im zweiten Prüfmodus ist die erste Leuchtdiode D2A inaktiv.

Die zweite Leuchtdiode D2B ist mit der Speicherschaltung 36 verbunden. Im ersten Prüfmodus ist die zweite Leuchtdiode D2B inaktiv. Im zweiten Prüfmodus leuchtet die zweite Photodiode D2B abhängig von dem Ladezustand des Speicherglieds 36.

Die beiden Photodioden D3A, D3B sind jeweils mit dem Schutzschalter 35 gekoppelt und steuern den Schutzschalter 35 abhängig von dem Leuchtzustand der ersten Leuchtdiode D2A und/oder der zweiten Leuchtdiode D2B an, um zu bewirken, dass die interne elektrische Leitung wahlweise unterbrochen oder nicht unterbrochen wird.

Exemplarisch wird die interne elektrische Leitung 37 im ersten Prüfmodus in Ansprechen darauf unterbrochen, dass das Messpotential MP kleiner als das erste Vergleichspotential VP1 ist. In diesem Fall nimmt das Komparatorsignal KS einen niedrigen Pegel, insbesondere einen L-Pegel, an, so dass ein Strom durch die erste Leuchtdiode D2A fließt und die erste Photodiode D3A angeregt wird und ein Signal bereitstellt, das wiederum bewirkt, dass der Schutzschalter 35 die interne elektrische Leitung 2 unterbricht.

Exemplarisch wird die interne elektrische Leitung 37 im zweiten Prüfmodus in Ansprechen darauf unterbrochen, dass das Messpotential MP größer als das zweite Vergleichspotential VP2 ist. In diesem Fall nimmt das Komparatorsignal KS einen hohen Pegel, insbesondere einen H-Pegel, an, so dass das Speicherglied 36 geladen wird und schließlich der Transistor T8 schaltet, so dass ein Strom durch die zweite Leuchtdiode D2B fließt und die zweite Photodiode D3B angeregt wird und ein Signal bereitstellt, das wiederum bewirkt, dass der Schutzschalter 35 die interne elektrische Leitung 37 unterbricht.

Exemplarisch ist seriell zur ersten Leuchtdiode D2A ein Widerstand R15 geschaltet. Gemäß einer nicht gezeigten Ausgestaltung ist ein entsprechender Widerstand in der Schaltungsimplementierung gemäß Figur 4 vorhanden.

Ferner ist exemplarisch ein Widerstand R16 zwischen den Kondensator C1 und den Ausgang der Komparatorschaltung 5 geschaltet, um das Eingangssignal des Transistors T8 zu glätten. Gemäß einer nicht gezeigten Ausgestaltung ist ein entsprechender Widerstand in der Schaltungsimplementierung gemäß Figur 4 vorhanden.

Rein optional umfasst die Schutzleiterüberwachungseinrichtung 300 ferner einen Funktionstest-Schalter 34, eine Funktionstest-Betätigungseinrichtung 41 und eine Funktionstest-Schaltungsanordnung, die exemplarisch die als Spannungsteiler geschalteten Widerstände R17 und R18 umfasst.

Durch Betätigung der Funktionstest-Betätigungseinrichtung 41 kann ein Benutzer bewirken, dass der Funktionstest-Schalter 34 umgelegt wird, so dass der Knoten 3a mit einem Zuführpotential verbunden wird, das zwischen den Widerständen R17, R18 bereitgestellt wird. Die Widerstände R17, R18 sind als Spannungsteiler zwischen den zweiten Anschlusspunkt 7, insbesondere den Phasenleiter 8, und den dritten Anschlusspunkt 9, insbesondere den Neutralleiter 10, geschaltet. Durch das Umlegen des Funktionstest-Schalters 34 kann das am ersten Eingang 25 anliegende Messpotential MP zu einem Funktionstestpotential geändert werden. Das Funktionstestpotential bewirkt, dass (bei korrekter Funktion der Schutzleiterüberwachungseinrichtung 300) der Schutzschalter 35 die interne elektrische Leitung 37 unterbricht, zweckmäßigerweise im ersten und/oder zweiten Prüfmodus. Auf diese Weise kann die Funktion der Schutzleiterüberwachungseinrichtung 300 getestet werden.

Die Schutzleiterüberwachungseinrichtung 300 kann auch ohne den Funktionstest-Schalter 34, die Funktionstest-Betätigungseinrichtung 41 und die Funktionstest-Schaltungsanordnung bereitgestellt werden. In diesem Fall kann der Knoten 3a direkt mit dem ersten Anschlusspunkt 3 verbunden sein, wie exemplarisch in den Figuren 2 und 3 gezeigt.

## Patentansprüche

1. Schutzleiterüberwachungseinrichtung (100; 200; 300) zur Erkennung einer Schutzleiterstörung einer elektrischen Leitung (2), wobei die Schutzleiterüberwachungseinrichtung (100; 200; 300) über einen ersten Anschlusspunkt (3) verfügt, der mit einem Schutzleiter (4) der elektrischen Leitung (2) verbindbar ist, eine erste Schaltungsanordnung (12), die ausgebildet ist, ein elektrisches Messpotential (MP) bereitzustellen, das von einem Potential (AP) des ersten Anschlusspunkts (3) abhängt, eine zweite Schaltungsanordnung (13), die ausgebildet ist, ein erstes elektrisches Vergleichspotential (VP1) bereitzustellen und eine eine Differenzverstärkerschaltung (16) aufweisende Komparatoreinrichtung (5), die ausgebildet ist, ein Komparatorsignal (KS) gemäß einem Vergleich des Messpotentials (MP) mit dem ersten Vergleichspotential (VP) bereitzustellen, wobei die Schutzleiterüberwachungseinrichtung (100; 200; 300) ferner über eine elektrisch leitende Berührungsfläche (20) zur Berührung durch einen Benutzer verfügt, die für den Benutzer zugänglich an der Schutzleiterüberwachungseinrichtung (100; 200; 300) angeordnet ist, und die zweite Schaltungsanordnung (13) ausgebildet ist, das erste Vergleichspotential (VP1) in Abhängigkeit von einem an der Berührungsfläche (20) anliegenden Potential (BP) bereitzustellen.

2. Schutzleiterüberwachungseinrichtung (100; 200; 300) nach Anspruch 1, **dadurch gekennzeichnet, dass** die Schutzleiterüberwachungseinrichtung (100; 200; 300) ausgebildet ist, das Komparatorsignal (KS) in Abhängigkeit davon bereitzustellen, ob ein erster Zustand oder ein zweiter Zustand vorliegt, wobei der ersten Zustand den Zustand umfasst, dass die Berührungsfläche (20) mit dem Körper des Benutzers in elektrisch leitender Verbindung steht und auf dem Schutzleiter (4) kein Fremdpotential vorhanden ist, und wobei der zweite Zustand wenigstens einen der folgenden Zustände umfasst: einen Zustand, dass die Berührungsfläche (20) nicht von einem Benutzer berührt wird, einen Zustand, dass die Berührungsfläche (20) mit elektrisch isolierendem Material berührt wird, einen Zustand, dass auf dem Schutzleiter (4) eine Fremdspannung vorhanden ist.

3. Schutzleiterüberwachungsvorrichtung (100; 200; 300) nach Anspruch 1 oder 2, **dadurch gekennzeichnet, dass** die Schutzleiterüberwachungsvorrichtung (100; 200; 300) ferner umfasst: eine vorzugsweise mit einer Gleichrichterbrücke ausgestattete Gleichrichteranordnung (11), die über zwei Ausgangsanschlusspunkte (14, 15) verfügt und ausgebildet ist, eine an der Schutzleiterüberwachungsvorrichtung (100; 200; 300) anliegende Wechselspannung in eine gleichgerichtete Spannung zu wandeln und diese an den beiden Ausgangsanschlusspunkten (14, 15) bereitzustellen.

4. Schutzleiterüberwachungsvorrichtung (100; 200; 300) nach Anspruch 3, **dadurch gekennzeichnet, dass** die zweite Schaltungsanordnung (13) insbesondere einen zweiten Spannungsteiler umfasst und ausgebildet ist, das erste Vergleichspotential (VP1) basierend auf einer Spannung bereitzustellen, die zwischen dem ersten Ausgangsanschlusspunkt (14) der Gleichrichteranordnung (11) und der Berührungsfläche (20) anliegt.

5. Schutzleiterüberwachungsvorrichtung (100; 200; 300) nach Anspruch 3 oder 4, **dadurch gekennzeichnet, dass** die erste Schaltungsanordnung (12) insbesondere einen ersten Spannungsteiler umfasst und ausgebildet ist, das Messpotential (MP) basierend auf einer Spannung bereitzustellen, die zwischen dem ersten Ausgangsanschlusspunkt (14) der Gleichrichteranordnung (11) und einem mit dem ersten Anschlusspunkt (3) elektrisch verbundenen Knoten (3a) anliegt.

6. Schutzleiterüberwachungsvorrichtung (100; 200; 300) nach einem der Ansprüche 3 bis 5, **dadurch gekennzeichnet, dass** die Schutzleiterüberwachungsvorrichtung (200; 300) über eine dritte Schaltungsanordnung (18) verfügt, die insbesondere einen dritten Spannungsteiler umfasst und ausgebildet ist, ein zweites elektrisches Vergleichspotential (VP2) bereitzustellen, und die Komparatoreinrichtung (5) ausgebildet ist, das Komparatorsignal (KS) basierend auf einem Vergleich des elektrischen Messpotentials (MP) mit dem zweiten elektrischen Vergleichspotential (VP2) bereitzustellen.

7. Schutzleiterüberwachungsvorrichtung (100; 200; 300) nach Anspruch 6, **dadurch gekennzeichnet, dass** die Schutzleiterüberwachungsvorrichtung (200; 300) ausgebildet ist, wahlweise einen ersten Prüfmodus oder einen zweiten Prüfmodus einzunehmen, wobei die Komparatoreinrichtung (5) ausgebildet ist, in dem ersten Prüfmodus das Komparatorsignal (KS) basierend auf dem Vergleich zwischen dem Messpotential (MP) und dem ersten Vergleichspotential (VP1) bereitzustellen, und ausgebildet ist, in dem zweiten Prüfmodus das Komparatorsignal (KS) basierend auf dem Vergleich zwischen dem Messpotential (MP) und dem zweiten Vergleichspotential (VP2) bereitzustellen.

8. Schutzleiterüberwachungsvorrichtung (100; 200; 300) nach Anspruch 7, **dadurch gekennzeichnet, dass** die Differenzverstärkerschaltung (16) ausgebildet ist, in dem ersten Prüfmodus das Messpotential (MP) mit dem ersten Vergleichspotential (VP1) zu vergleichen, und ausgebildet ist, in dem zweiten Prüfmodus das Messpotential (MP) mit dem zweiten Vergleichspotential (VP2) zu vergleichen.

9. Schutzleiterüberwachungsvorrichtung (100; 200; 300) nach Anspruch 8 **dadurch gekennzeichnet, dass** die Differenzverstärkerschaltung (16) über drei Eingänge (25, 26, 27) verfügt, wobei die erste Schaltungsanordnung (12) ausgebildet ist, an dem ersten Eingang (25) das Messpotential (MP) bereitzustellen, die zweite Schaltungsanordnung (13) ausgebildet ist, an dem zweiten Eingang (26) im ersten Prüfmodus das erste Vergleichspotential (VP1) bereitzustellen, und die dritte Schaltungsanordnung (18) ausgebildet ist, an dem dritten Eingang (27) im zweiten Prüfmodus das zweite Vergleichspotential (VP2) bereitzustellen.

10. Schutzleiterüberwachungsvorrichtung (100; 200; 300) nach Anspruch 9, **dadurch gekennzeichnet, dass** die Schutzleiterüberwachungsvorrichtung (200; 300) ausgebildet ist, in dem ersten Prüfmodus zu verhindern, dass der Differenzverstärkerschaltung (16) das zweite Vergleichspotential (VP2) bereitgestellt wird, und in dem zweiten Prüfmodus zu verhindern, dass der Differenzverstärkerschaltung (16) das erste Vergleichspotential (VP1) bereitgestellt wird.

11. Schutzleiterüberwachungsvorrichtung (100; 200; 300) nach einem der Ansprüche 7 bis 10, **dadurch gekennzeichnet, dass** die Schutzleiterüberwachungsvorrichtung (100; 200; 300) über eine Betätigungseinrichtung (29) verfügt, an der vorzugsweise die Berührungsfläche (20) angeordnet ist und über die die Schutzleiterüberwachungsvorrichtung (100; 200; 300) wahlweise in den ersten Prüfmodus oder in den zweiten Prüfmodus versetzt werden kann.

12. Schutzleiterüberwachungsvorrichtung (100; 200; 300) nach einem der Ansprüche 7 bis 11, **dadurch gekennzeichnet, dass** die Schutzleiterüberwachungsvorrichtung (100; 200; 300) über einen Schutzschalter (35) verfügt und ausgebildet ist, in Ansprechen auf das Komparatorsignal (KS) wenigstens eine mit dem ersten Anschlusspunkt (3), zweiten Anschlusspunkt (7) und/oder dritten Anschlusspunkt (9) verbundene interne elektrische Leitung (37) mit Hilfe des Schutzschalters (35) zu unterbrechen, wobei die Schutzleiterüberwachungsvorrichtung (100; 200; 300) ausgebildet ist, im ersten Prüfmodus die interne elektrische Leitung (37) bei einem ersten Komparatorsignal-Zustand des Komparatorsignals (KS) nicht zu unterbrechen und bei einem von dem ersten Komparatorsignal-Zustand verschiedenen zweiten Komparatorsignal-Zustand des Komparatorsignals (KS) zu unterbrechen, und ausgebildet ist, im zweiten Prüfmodus die interne elektrische Leitung (37) bei dem zweiten Komparatorsignal-Zustand nicht zu unterbrechen und bei dem ersten Komparatorsignal-Zustand zu unterbrechen.

13. Stromverteilervorrichtung (1) zur Bereitstellung einer von einer elektrischen Leitung (2) zugeführten Netzspannung an einen oder mehrere Verbraucher, umfassend eine Schutzleiterüberwachungseinrichtung (100; 200; 300) nach einem der voranstehenden Ansprüche.

14. Stromverteilervorrichtung (1) nach Anspruch 13, **gekennzeichnet durch** einen Netzstecker (22) und/oder eine Steckdose (23), wobei der erste Anschlusspunkt (3), der zweite Anschlusspunkt (7) und der dritte Anschlusspunkt (9) mit jeweiligen Kontakten des Netzsteckers (22) und/oder der Steckdose (23) elektrisch verbunden sind.

15. Schutzleiterüberwachungsverfahren zur Erkennung einer Schutzleiterstörung auf einer mit einem Schutzleiter (4) ausgestatteten elektrischen Leitung (2), mit den Schritten: Bereitstellen eines Messpotentials (MP), das von einem Potential des Schutzleiters (4) abhängt, Bereitstellen eines ersten elektrischen Vergleichspotentials (VP1), das in einem Zustand, in dem ein Benutzer eine elektrisch leitende Berührungsfläche (20) mit seinem Körper berührt, von dem lokalen Erdpotential des Benutzers abhängt, Vergleichen, unter Verwendung einer eine Differenzverstärkerschaltung (16) aufweisenden Komparatoreinrichtung (5) des elektrischen Messpotentials (MP) mit dem ersten elektrischen Vergleichspotential (VP1) und Bereitstellen, gemäß dem Vergleichsergebnis, eines Komparatorsignals (KS) zur Erkennung einer Schutzleiterstörung.

## Claims

1. Protective conductor monitoring device (100; 200; 300) for detecting a protective conductor fault in an electrical line (2), the protective conductor monitoring device (100; 200; 300) having a first connection point (3) which can be connected to a protective conductor (4) of the electrical line (2), a first circuit arrangement (12) which is designed to provide an electrical measurement potential (MP) which depends on a potential (AP) of the first connection point (3), a second circuit arrangement (13) which is designed to provide a first electrical comparison potential (VP1), and a comparator device (5) which has a differential amplifier circuit (16) and is designed to provide a comparator signal (KS) in accordance with a comparison of the measurement potential (MP) with the first comparison potential (VP), wherein the protective conductor monitoring device (100; 200; 300) further has an electrically conductive contact surface (20 ) for contact by a user, which is arranged on the protective conductor monitoring device (100; 200; 300) in a manner accessible to the user, and the second circuit arrangement (13) is designed to provide the first comparison potential (VP1) as a function of a potential (BP) present at the contact surface (20).

2. Protective conductor monitoring device (100; 200; 300) according to claim 1, **characterized in that** the protective conductor monitoring device (100; 200; 300) is designed to provide the comparator signal (KS) depending on whether a first state or a second state is present, the first state comprising the state in which the contact surface (20) is in electrically conductive connection with the body of the user and no external potential is present on the protective conductor (4), and the second state comprising at least one of the following states: a state in which the contact surface (20) is not touched by a user, a state in which the contact surface (20) is touched by electrically insulating material, a state in which an external voltage is present on the protective conductor (4).

3. Protective conductor monitoring device (100; 200; 300) according to claim 1 or 2, **characterized in that** the protective conductor monitoring device (100; 200; 300) further comprises: a rectifier arrangement (11) preferably equipped with a rectifier bridge, which has two output connection points (14, 15) and is designed to convert an alternating voltage applied to the protective conductor monitoring device (100; 200; 300) into a rectified voltage and to provide this at the two output connection points (14, 15).

4. Protective conductor monitoring device (100; 200; 300) according to claim 3, **characterized in that** the second circuit arrangement (13) in particular comprises a second voltage divider and is designed to provide the first comparison potential (VP1) based on a voltage that is present between the first output connection point (14) of the rectifier arrangement (11) and the contact surface (20).

5. Protective conductor monitoring device (100; 200; 300) according to claim 3 or 4, **characterized in that** the first circuit arrangement (12) in particular comprises a first voltage divider and is designed to provide the measurement potential (MP) based on a voltage applied between the first output connection point (14) of the rectifier arrangement (11) and a node (3a) electrically connected to the first connection point (3).

6. Protective conductor monitoring device (100; 200; 300) according to one of claims 3 to 5, **characterized in that** the protective conductor monitoring device (200; 300) has a third circuit arrangement (18) which in particular comprises a third voltage divider and is designed to provide a second electrical comparison potential (VP2), and the comparator device (5) is designed to provide the comparator signal (KS) based on a comparison of the electrical measurement potential (MP) with the second electrical comparison potential (VP2).

7. Protective conductor monitoring device (100; 200; 300) according to claim 6, **characterized in that** the protective conductor monitoring device (200; 300) is designed to selectively assume a first checking mode or a second checking mode, the comparator device (5) being designed to provide, in the first checking mode, the comparator signal (KS) based on the comparison between the measurement potential (MP) and the first comparison potential (VP1), and being designed to provide, in the second checking mode, the comparator signal (KS) based on the comparison between the measurement potential (MP) and the second comparison potential (VP2).

8. Protective conductor monitoring device (100; 200; 300) according to claim 7, **characterized in that** the differential amplifier circuit (16) is designed to compare, in the first checking mode, the measurement potential (MP) with the first comparison potential (VP1), and is designed to compare, in the second checking mode, the measurement potential (MP) with the second comparison potential (VP2).

9. Protective conductor monitoring device (100; 200; 300) according to claim 8, **characterized in that** the differential amplifier circuit (16) has three inputs (25, 26, 27), the first circuit arrangement (12) being designed to provide the measurement potential (MP) at the first input (25), the second circuit arrangement (13) being designed to provide the first comparison potential (VP1) at the second input (26) in the first checking mode, and the third circuit arrangement (18) being designed to provide the second comparison potential (VP2) at the third input (27) in the second checking mode.

10. Protective conductor monitoring device (100; 200; 300) according to claim 9, **characterized in that** the protective conductor monitoring device (200; 300) is designed to prevent, in the first checking mode, the second comparison potential (VP2) from being provided to the differential amplifier circuit (16), and to prevent, in the second checking mode, the first comparison potential (VP1) from being provided to the differential amplifier circuit (16).

11. Protective conductor monitoring device (100; 200; 300) according to one of claims 7 to 10, **characterized in that** the protective conductor monitoring device (100; 200; 300) has an operating device (29), on which the contact surface (20) is preferably arranged and via which the protective conductor monitoring device (100; 200; 300) can be selectively set to the first checking mode or to the second checking mode.

12. Protective conductor monitoring device (100; 200; 300) according to one of claims 7 to 11, **characterized in that** the protective conductor monitoring device (100; 200; 300) has a protective switch (35) and is designed to interrupt, in response to the comparator signal (KS), at least an internal electrical line (37) connected to the first connection point (3), second connection point (7) and/or third connection point (9) with the aid of the protective switch (35), wherein the protective conductor monitoring device (100; 200; 300) is designed, in the first checking mode, not to interrupt the internal electrical line (37) in the case of a first comparator signal state of the comparator signal (KS) and to interrupt it in the case of a second comparator signal state of the comparator signal (KS) which is different from the first comparator signal state, and is designed, in the second checking mode, not to interrupt the internal electrical line (37) in the case of the second comparator signal state and to interrupt it in the case of the first comparator signal state.

13. Current distribution device (1) for providing a mains voltage supplied by an electrical line (2) to one or more consumers, comprising a protective conductor monitoring device (100; 200; 300) according to one of the preceding claims.

14. Power distribution device (1) according to claim 13, **characterized by** a mains plug (22) and/or a socket (23), wherein the first connection point (3), the second connection point (7) and the third connection point (9) are electrically connected to respective contacts of the mains plug (22) and/or the socket (23).

15. Protective conductor monitoring method for detecting a protective conductor fault on an electrical line (2) equipped with a protective conductor (4), comprising the steps: providing a measurement potential (MP) which depends on a potential of the protective conductor (4), providing a first electrical comparison potential (VP1) which, in a state in which a user touches an electrically conductive contact surface (20) with his body, depends on the local earth potential of the user, comparing, using a comparator device (5) comprising a differential amplifier circuit (16), the electrical measurement potential (MP) with the first electrical comparison potential (VP1) and providing, in accordance with the comparison result, a comparator signal (KS) for detecting a protective conductor fault.

## Revendications

1. Système de surveillance de conducteur de protection (100 ; 200 ; 300) pour la détection d'une défaillance de conducteur de protection d'une ligne électrique (2), dans lequel le système de surveillance de conducteur de protection (100 ; 200 ; 300) dispose d'un premier point de raccordement (3), qui peut être relié à un conducteur de protection (4) de la ligne électrique (2), d'un premier ensemble de circuit (12), qui est réalisé pour fournir un potentiel de mesure électrique (MP), qui dépend d'un potentiel (AP) du premier point de raccordement (3), d'un deuxième ensemble de circuit (13), qui est réalisé pour fournir un premier potentiel de comparaison électrique (VP1) et d'un système de comparateur (5) présentant un circuit d'amplificateur différentiel (16), qui est réalisé pour fournir un signal de comparateur (KS) conformément à une comparaison du potentiel de mesure (MP) au premier potentiel de comparaison (VP), dans lequel le système de surveillance de conducteur de protection (100 ; 200 ; 300) dispose en outre d'une surface de contact (20) électro-conductrice destinée à être touchée par un utilisateur, qui est disposée sur le système de surveillance de conducteur de protection (100 ; 200 ; 300) de manière à être accessible à l'utilisateur, et le deuxième ensemble de circuit (13) est réalisé pour fournir le premier potentiel de comparaison (VP1) en fonction d'un potentiel (BP) s'appliquant à la surface de contact (20).

2. Système de surveillance de conducteur de protection (100 ; 200 ; 300) selon la revendication 1, **caractérisé en ce que** le système de surveillance de conducteur de protection (100 ; 200 ; 300) est réalisé pour fournir le signal de comparateur (KS) selon qu'un premier état ou un deuxième état est présent, dans lequel le premier état comprend l'état, dans lequel la surface de contact (20) est en liaison électro-conductrice avec le corps de l'utilisateur et aucun potentiel extérieur n'est présent sur le conducteur de protection (4), et dans lequel le deuxième état comprend au moins un des états suivants : un état dans lequel la surface de contact (20) n'est pas touchée par un utilisateur, un état dans lequel la surface de contact (20) est touchée avec un matériau électroisolant, un état dans lequel une tension extérieure est présente sur le conducteur de protection (4).

3. Dispositif de surveillance de conducteur de protection (100 ; 200 ; 300) selon la revendication 1 ou 2, **caractérisé en ce que** le dispositif de surveillance de conducteur de protection (100 ; 200 ; 300) comprend en outre : un ensemble de redresseur (11) équipé de préférence d'un pont redresseur, qui dispose de deux points de raccordement de sortie (14, 15) et est réalisé pour convertir une tension alternative s'appliquant au dispositif de surveillance de conducteur de protection (100 ; 200 ; 300) en une tension redressée et pour fournir celle-ci sur les deux points de raccordement de sortie (14, 15).

4. Dispositif de surveillance de conducteur de protection (100 ; 200 ; 300) selon la revendication 3, **caractérisé en ce que** le deuxième ensemble de circuit (13) comprend en particulier un deuxième diviseur de tension et est réalisé pour fournir le premier potentiel de comparaison (VP1) sur la base d'une tension qui s'applique entre le premier point de raccordement de sortie (14) de l'ensemble de redresseur (11) et la surface de contact (20).

5. Dispositif de surveillance de conducteur de protection (100 ; 200 ; 300) selon la revendication 3 ou 4, **caractérisé en ce que** le premier ensemble de circuit (12) comprend en particulier un premier diviseur de tension et est réalisé pour fournir le potentiel de mesure (MP) sur la base d'une tension qui s'applique entre le premier point de raccordement de sortie (14) de l'ensemble de redresseur (11) et un noeud (3a) relié électriquement au premier point de raccordement (3).

6. Dispositif de surveillance de conducteur de protection (100 ; 200 ; 300) selon l'une quelconque des revendications 3 à 5, **caractérisé en ce que** le dispositif de surveillance de conducteur de protection (200 ; 300) dispose d'un troisième ensemble de circuit (18), qui comprend en particulier un troisième diviseur de tension et est réalisé pour fournir un deuxième potentiel de comparaison électrique (VP2), et le système de comparateur (5) est réalisé pour fournir le signal de comparateur (KS) sur la base d'une comparaison du potentiel de mesure (MP) électrique avec le deuxième potentiel de comparaison (VP2) électrique.

7. Dispositif de surveillance de conducteur de protection (100 ; 200 ; 300) selon la revendication 6, **caractérisé en ce que** le dispositif de surveillance de conducteur de protection (200 ; 300) est réalisé pour occuper sélectivement un premier mode de contrôle ou un deuxième mode de contrôle, dans lequel le système de comparateur (5) est réalisé dans le premier mode de contrôle pour fournir le signal de comparateur (KS) sur la base de la comparaison entre le potentiel de mesure (MP) et le premier potentiel de comparaison (VP1), et est réalisé dans le deuxième mode de contrôle pour fournir le signal de comparateur (KS) sur la base de la comparaison entre le potentiel de mesure (MP) et le deuxième potentiel de comparaison (VP2).

8. Dispositif de surveillance de conducteur de protection (100 ; 200 ; 300) selon la revendication 7, **caractérisé en ce que** le circuit d'amplificateur différentiel (16) est réalisé dans le premier mode de contrôle pour comparer le potentiel de mesure (MP) avec le premier potentiel de comparaison (VP1), et est réalisé dans le deuxième mode de contrôle pour comparer le potentiel de mesure (MP) avec le deuxième potentiel de comparaison (VP2).

9. Dispositif de surveillance de conducteur de protection (100 ; 200 ; 300) selon la revendication 8, **caractérisé en ce que** le circuit d'amplificateur différentiel (16) dispose de trois entrées (25, 26, 27), dans lequel le premier ensemble de circuit (12) est réalisé pour fournir sur la première entrée (25) le potentiel de mesure (MP), le deuxième ensemble de circuit (13) est réalisé pour fournir sur la deuxième entrée (26) dans le premier mode de contrôle le premier potentiel de comparaison (VP1), et le troisième ensemble de circuit (18) est réalisé pour fournir sur la troisième entrée (27) dans le deuxième mode de contrôle le deuxième potentiel de comparaison (VP2).

10. Dispositif de surveillance de conducteur de protection (100 ; 200 ; 300) selon la revendication 9, **caractérisé en ce que** le dispositif de surveillance de conducteur de protection (200 ; 300) est réalisé dans le premier mode de contrôle pour empêcher que le deuxième potentiel de comparaison (VP2) soit fourni au circuit d'amplificateur différentiel (16), et dans le deuxième mode de contrôle pour empêcher que le premier potentiel de comparaison (VP1) soit fourni au circuit d'amplificateur différentiel (16).

11. Dispositif de surveillance de conducteur de protection (100 ; 200 ; 300) selon l'une quelconque des revendications 7 à 10, **caractérisé en ce que** le dispositif de surveillance de conducteur de protection (100 ; 200 ; 300) dispose d'un système d'actionnement (29), sur lequel de préférence la surface de contact (20) est disposée et par l'intermédiaire duquel le dispositif de surveillance de conducteur de protection (100 ; 200 ; 300) peut être amené sélectivement dans le premier mode de contrôle ou dans le deuxième mode de contrôle.

12. Dispositif de surveillance de conducteur de protection (100 ; 200 ; 300) selon l'une quelconque des revendications 7 à 11, **caractérisé en ce que** le dispositif de surveillance de conducteur de protection (100 ; 200 ; 300) dispose d'un disjoncteur (35) et est réalisé en réponse au signal de comparateur (KS) pour interrompre au moins une ligne électrique interne (37) reliée au premier point de raccordement (3), deuxième point de raccordement (7) et/ou troisième point de raccordement (9) à l'aide du disjoncteur (35), dans lequel le dispositif de surveillance de conducteur de protection (100 ; 200 ; 300) est réalisé dans le premier mode de contrôle pour ne pas interrompre la ligne électrique interne (37) lors d'un premier état de signal de comparateur du signal de comparateur (KS) et pour l'interrompre lors d'un deuxième état de signal de comparateur du signal de comparateur (KS) différent du premier état de signal de comparateur, et est réalisé dans le deuxième mode de contrôle pour ne pas interrompre la ligne électrique interne (37) lors du deuxième état de signal de comparateur et pour l'interrompre lors du premier état de signal de comparateur.

13. Dispositif de distribution de courant (1) pour la fourniture d'une tension de réseau amenée par une ligne électrique (2) à un ou plusieurs consommateurs, comprenant un système de surveillance de conducteur de protection (100 ; 200 ; 300) selon l'une quelconque des revendications précédentes.

14. Dispositif de distribution de courant (1) selon la revendication 13, **caractérisé par** une fiche de prise de courant (22) et/ou une prise de courant (23), dans lequel le premier point de raccordement (3), le deuxième point de raccordement (7) et le troisième point de raccordement (9) sont reliés électriquement aux contacts respectifs de la fiche de prise de courant (22) et/ou de la prise de courant (23).

15. Procédé de surveillance de conducteur de protection pour la détection d'une défaillance de conducteur de protection sur une ligne électrique (2) équipée d'un conducteur de protection (4), avec les étapes :
de fourniture d'un potentiel de mesure (MP), qui dépend d'un potentiel du conducteur de protection (4), de fourniture d'un premier potentiel de comparaison électrique (VP1) qui, dans un état dans lequel un utilisateur touche une surface de contact (20) électro-conductrice avec son corps, dépend du potentiel de terre local de l'utilisateur, de comparaison, au moyen d'un système de comparateur (5), du potentiel de mesure (MP) électrique présentant un circuit d'amplificateur différentiel (16) avec le premier potentiel de comparaison électrique (VP1) et de fourniture, conformément au résultat de comparaison, d'un signal de comparateur (KS) pour la détection d'une défaillance de conducteur de protection.
